Europäisches Patentamt

European Patent Office

Office européen des brevets

(11) Publication number: **0 198 254**
**A1**

## (12) EUROPEAN PATENT APPLICATION

(21) Application number: 86103657.2

(51) Int. Cl.⁴: **H03K 5/04**

(22) Date of filing: 18.03.86

(30) Priority: 18.03.85 JP 53653/85

(43) Date of publication of application:
22.10.86 Bulletin 86/43

(84) Designated Contracting States:
DE FR GB

(71) Applicant: NEC CORPORATION
33-1, Shiba 5-chome, Minato-ku
Tokyo 108(JP)

(72) Inventor: Akatsuka, Yasuo
NEC Corporation 33-1, Shiba 5-chome
Minato-ku Tokyo(JP)

(74) Representative: Glawe, Delfs, Moll & Partner
Patentanwälte
Postfach 26 01 62 Liebherrstrasse 20
D-8000 München 26(DE)

(54) Pulse width modifying circuit.

(57) A pulse width modifying circuit comprises at least one first type of complementary metal-oxide-semiconductor (CMOS) inverter and at least one second type of CMOS inverter which are alternately connected in cascade to form an inverter train. The first type CMOS inverter includes an N-channel MOS field effect transistor (FET) having a transconductance larger than that of an associated P-channel MOSFET, and the second type CMOS inverter includes a P-channel MOSFET having a transconductance larger than that of an associated N-channel MOSFET.

## FIGURE 4

$$g_{mN} > g_{mP} \quad g_{mN} < g_{mP} \quad g_{mN} > g_{mP} \quad g_{mN} < g_{mP}$$

EP 0 198 254 A1

## PULSE WIDTH MODIFYING CIRCUIT

### Background of the Invention

#### Field of the Invention

The present invention relates to a pulse generator, and more specifically to a pulse width modifying circuit in the form of complementary metal-oxide-semiconductor device.

#### Description of related art

In general, conversion or modification of pulse width in pulse signals are fundamentally usable and indispensable in design of systems and larger scaled integrated circuits.

Heretofore, a typical circuit for pulse width modification has a delay circuit receiving an inputted pulse signal, and an OR circuit receiving the inputted pulse signal directly and a delayed signal from the delay circuit. With this arrangement, the OR circuit outputs a logical sum of the inputted signal and the delayed signal. Therefore, there is obtained a pulse signal whose pulse width is enlarged by the delay time given by the delay circuit. Thus, the degree of the enlargement of the pulse width is freely determined by suitably setting the delay time of the delay circuit.

However, when the pulse width of an input signal is smaller than the delay time of the delay circuit, the OR gate will output two separate pulse signals having the same pulse width as that of the input pulse. Namely, the circuit cannot provide a pulse signal having an increased pulse width. This problem cannot be avoided as far as a delay circuit is used in association with an OR circuit.

#### Summary of the Invention

Accordingly, it is an object of the present invention to provide a pulse width modifying circuit which has dissolved the above mentioned defects of the conventional circuit.

Another object of the present invention is to provide a pulse width modifying circuit which can provide a pulse signal whose pulse width is increased by a desired amount irrespectively of the pulse width of a input pulse signal.

Still another object of the present invention is to provide a pulse width modifying circuit which can provide a pulse signal having an increased pulse width without use of a delay circuit.

A further object of the present invention is to provide a pulse width modifying circuit which can be easily realized in an integrated circuit.

The above and other objects of the present invention are achieved in accordance with the present invention by a pulse width modifying circuit comprising at least one first type inverter and at least one second type inverter which are alternately connected in cascade to form an inverter train. The first type inverter is such that the delay of the rising edge of its output signal is larger than that of the falling edge of the output signal, and the second type inverter is such that the delay of the falling edge of its output signal is larger than that of the rising edge of the output signal.

Specifically, the circuit comprises the same numbers of the first and second type inverters, and in one embodiment, the first stage of the inverter train is the first type inverter. In another embodiment, the firt stage of the inverter train is the second type inverter.

More specifically, each first type inverter is a first type of complementary insulated gate field effect transistor (IGFET) inverter whose N-channel IGFET has a transconductance larger than that of an associated P-channel IGFET, and each second type inverter is a second type of complementary IGFET inverter whose N-channel IGFET has a transconductance larger than that of an associated N-channel IGFET.

In a preferred embodiment, the N-channel IGFET of the first type IGFET inverter has a transconductance as large as twice that of the associated P-channel IGFET, and the P-channel IGFET of the second type IGFET inverter has a transconductance as large as twice that of the associated N-channel IGFET.

Further, according to the present invention, there is provided a pulse width modifying circuit comprising at least one first type of CMOS inverter and at least one second type of CMOS inverter which are alternately connected in cascade to form an inverter train. The first type CMOS inverter includes an N-channel MISFIT having a transconductance larger than that of an associated P-channel MISFIT, and the second type CMOS inverter including a P-channel MISFIT having a transconductance larger than that of an associated N-channel MISFIT.

Specifically, the first and second types CMOS inverters include silicon MOSFETs which have a gate insulator film whose dielectric constant is 4.0 and whose thickness is 400 angstroms. Each of the MOSFETs has a gate length of 2 micrometers. The N-channel and P-channel MOSFETs of the first type inverters have the same gate width of 10 micrometers, and the N-channel and P-channel MOSFETs of the second type inverters have gate widths of 5 micrometers and 20 micrometers, respectively.

In CMOS inverters, if a pair of N-channel and P-channel MOSFETs have different transconductance, the rising and falling edges of an output pulse signal will differ from each other in the delay amount. Therefore, in the aforementioned first type CMOS inverter whose N-channel MOSFET has a transconductance larger than that of an associated P-channel MOSFET, the delay amount of the rising edge of an output signal is larger than that of the falling edge of the same output signal. Therefore, the duration from the falling edge to the rising edge of an inverted output signal becomes longer than that of the time from the rising edge to the falling edge of the inputted pulse signal. To the contrary, in the second type CMOS inverter having a P-channel MOSFET of a transconductance larger than an associated N-channel MOSFET, the delay amount of the falling edge of an output signal is larger than that of the rising edge of the same output signal. Accordingly, the period from the rising edge to the falling edge of an inverted output signal will be larger than that of the time from the falling edge to the rising edge of the inputted pulse signal.

Thus, in the pulse width modifying circuit in accordance with the present invention as mentioned above, if the first type CMOS inverter is put in the first stage of the inverter train, the circuit operates to increase the pulse width of a positive pulse signal. If the second type CMOS inverter is put in the first stage of the inverter train, the circuit outputs a negative pulse signal having an increased pulse width. This increase of the pulse width is given little by little at every passing through one CMOS inverter, and therefore, the inputted signal is never splitted into two separate pulses even if there is applied a pulse signal having a pulse width smaller than the increased amount of the pulse width to be given by the circuit.

Further, the increase of the pulse width in positive pulses means the decrease of the pulse width in the negative pulses. Accordingly, the pulse width modifying circuit can be used not only to increase the pulse width but also to decrease the pulse width.

In addition, the increase or decrease amount of the pulse width can be easily set by selecting the number of the CMOS inverters connected in cascade. Moreover, since the pulse width modifying circuit in accordance with the present invention is composed of only CMOS inverters without using a delay circuit, the circuit can be easily realized in an integrated circuit.

The above and other objects, features and advantages of the present invention will be apparent from the following description of preferred embodiments of the present invention with reference to the accompanying drawings.

Brief Description of the Drawings

Figure 1 is a functional block diagram of a conventional pulse width modifying circuit;

Figure 2 is a timing chart of signals at various points in the circuit shown in Figure 1,

Figure 3 is a chart similar to Figure 2 but showing the condition when a narrow pulse width signal is applied;

Figure 4 is a functional block diagram of a first embodiment of the pulse width modifying circuit in accordance with the present invention;

Figure 5 is a circuit diagram of a CMOS inverter which can be used in the circuit shown in Figure 4;

Figure 6 is a graph showing the relation between the transconductance $g_m$ and the delay $\Delta t$ in MOS transistors;

Figure 7 is a timing chart of signals at input and outputs of the respective CMOS inverters in the circuit shown in Figure 4;

Figure 8 is a transistor circuit diagram of the circuit shown in Figure 4;

Figure 9 is a diagram similar to Figure 4 but showing a second embodiment of the pulse width modifying circuit in accordance with the present invention; and

Figure 10 is a timing chart of signals at input and output of the circuit shown in Figure 9.

Description of the Preferred Embodiments

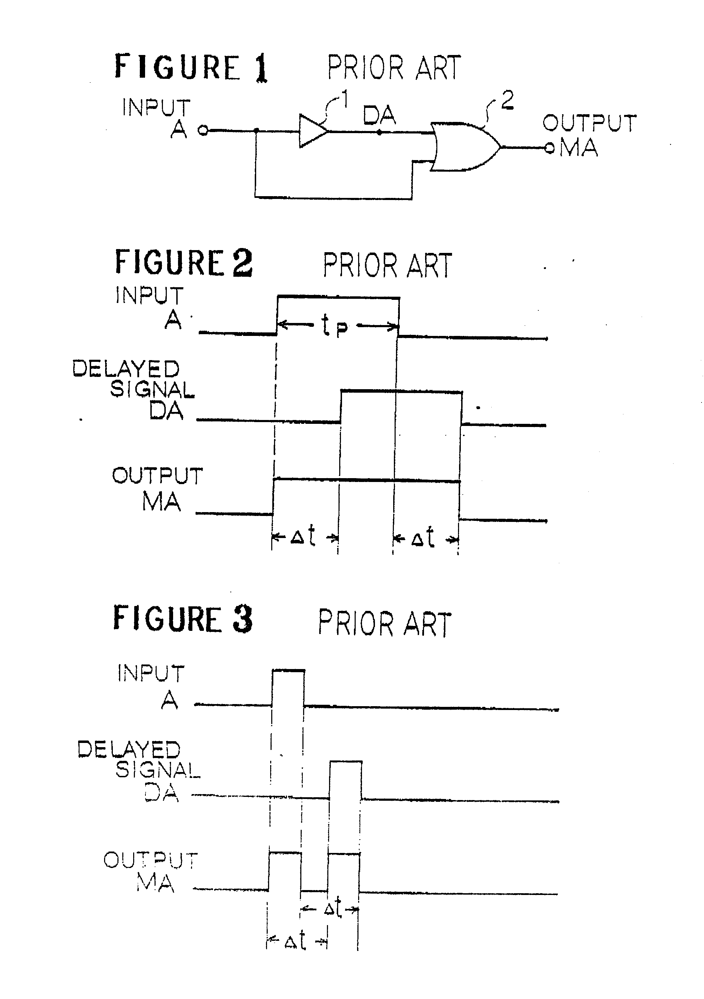

Referring to Figure 1, there is shown a typical example of the conventional pulse pulse width modifying circuit, which includes a delay circuit 1 receiving an input signal A, and an OR circuit 2 receiving at its one input the input signal A directly and at its other input an delayed signal DA from the delay circuit. As a result, as seen from Figure 2, if a pulse of the width $t_p$ is applied to the circuit, the circuit outputs a pulse signal MA having the pulse width which is increased by the delay time $\Delta t$ of the delay circuit 1. However, if an input pulse has the pulse width smaller than the delay time $\Delta t$

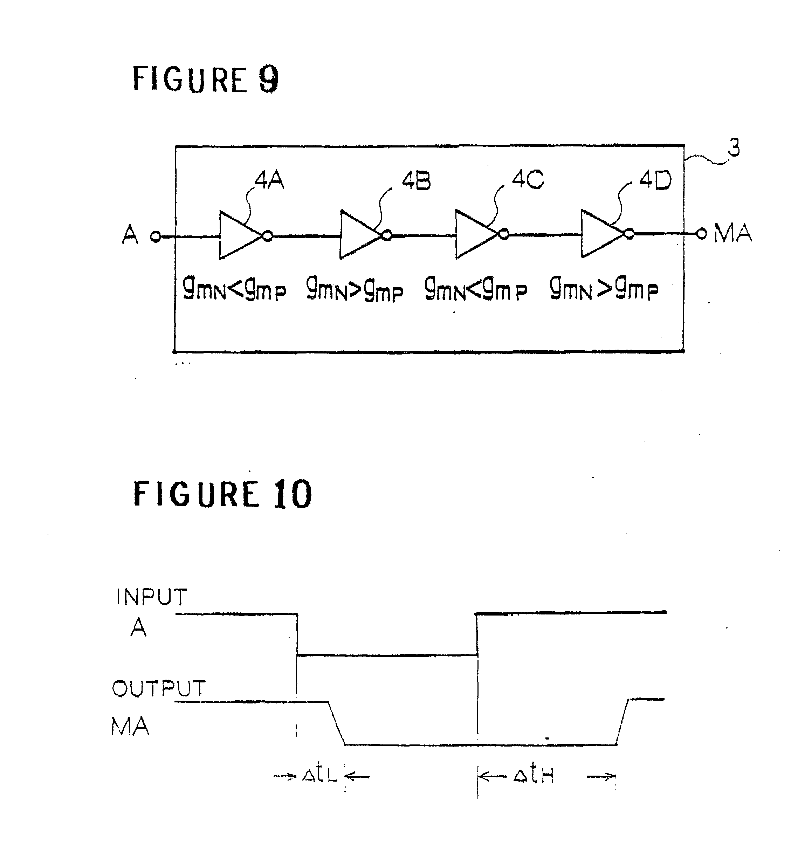

of the delay circuit, the OR circuit outputs two separate pulses as shown in Figure 10. This problem is inevitable as far as the delay circuit provides the increase of the pulse width.

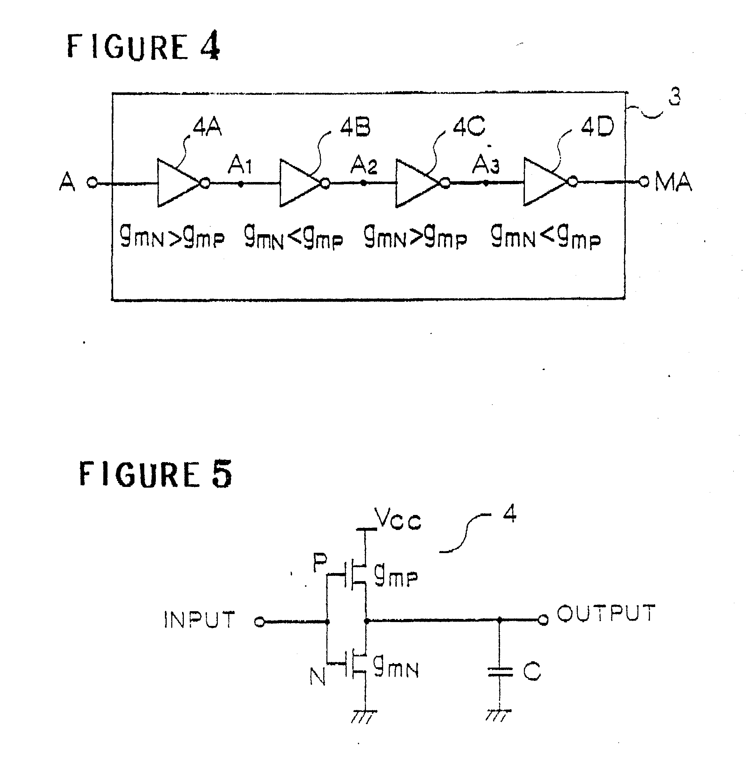

Turning to Figure 4, there is shown a first embodiment of the pulse width modifying circuit in accordance with the present invention. The shown circuit 3 comprises four cascade-connected inverters 4A, 4B, 4C and 4D which are constituted by CMOS devices, respectively. As shown in Figure 5, each of the CMOS inverters 4A, 4B, 4C and 4D comprises a pair of P-channel MOSFET and N-channel MOSFET which are common connected at their gates to its input and at their drains to its output. A source of the P-channel MOSFET is connected to a positive supply voltage Vcc, and a source of the N-channel MOSFET is grounded. The CMOS inverter also have at its output a capacitance C which functions as a load capacitance and which is provided by a parasitic capacitance of MOSFETs and a line capacitance.

In the pulse width modifying circuit as mentioned above, the odd-numbered CMOS inverters, i.e., the first and third CMOS inverters 4A and 4C are such that the N-channel MOSFET has a transconductance $g_{mN}$ larger than a transconductance $g_{mp}$ of an associated P-channel MOSFET. The even-numbered CMOS inverters, i.e., the second and fourth CMOS inverters 4B and 4D are such that the transconductance $g_{mp}$ of the P-channel MOSFET is larger than the transconductance $g_{mN}$ of an associated N-channel MOSFET.

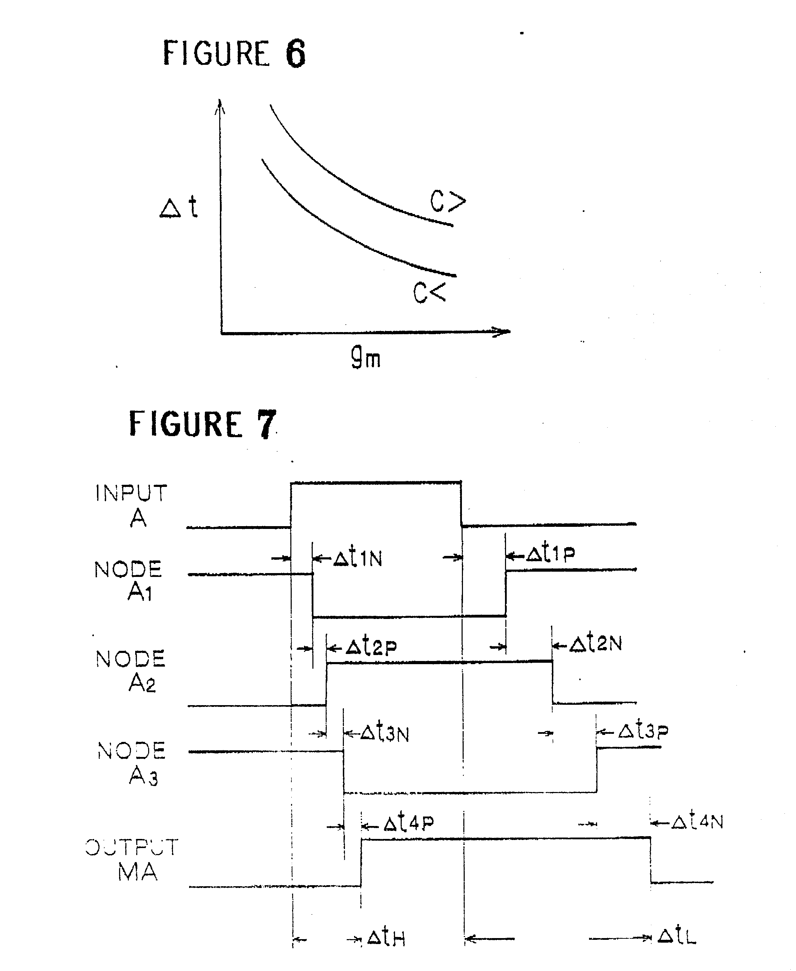

This transconductance $g_m$ determines the current driving ability, and as shown in Figure 6, the larger the transconductance $g_m$ is, the smaller the delay time $\Delta t$ in signal transmission is, which delay time is caused by the charging and discharging time of the load capacitance.

In the CMOS inverter, on the other hand, the P-channel MOSFET charges the load capacitance C, while the N-channel MOSFET discharges the load capacitance C. Therefore, if the transconductance $g_{mN}$ of the N-channel MOSFET is larger than the transconductance $g_{mN}$ of the N-channel MOSFET is larger than the transconductance $g_{mp}$ of the P-channel MOSFET, the delay time given by the discharge of the load capacitance C is shorter than that provided by the charge of the load capacitance C. To the contrary, if the transconductance $g_{mp}$ of the P-channel MOSFET is larger than the transconductance $g_{mN}$ of the N-channel MOSFET, the delay time defined by the charge of the load capacitance C is shorter than that also determined by the discharge of the load capacitance C.

Accordingly, assuming that $\Delta t_{iN}$ designates the delay time of the falling edge in the output signal of ith CMOS inverter (when its output signal changes from "1" to "0"), and $\Delta t_{ip}$ indicates the delay time of the rising edge in the output signal of ith CMOS inverter (when its output signal changes from "0" to "1"), the following relation is established:

$$\Delta t_{iN} < \Delta t_{ip} \quad i = \text{odd number}$$

$$\Delta t_{iN} > \Delta t_{ip} \quad i = \text{even number}$$

... (1)

The above relation is shown in Figure 7, which shows the waveforms of the input signal A of the first CMOS inverter and the output signals A1, A2, A3 and MA of the respective CMOS inverters. Here, assume in the circuit shown in Figure 4 that $\Delta t_H$ designates the delay time from the moment the input signal A changes from "0" to "1" to the moment the output signal MA changes from "0" to "1". Also assume that $\Delta t_L$ indicates the delay time from the moment the input signal A changes from "1" to "0" to the moment the output signal MA changes from "1" to "0". As a result, the following relation can be derived from the above equations - (1):

$$\Delta t_H \ll \Delta t_L \quad \text{... (2)}$$

Namely, there is obtained the output signal MA having the pulse width larger than that of the input signal A.

Therefore, it will be understood that the pulse width modifying circuit shown in Figure 4 can output a pulse signal having an increase pulse width, by suitably setting the transconductances of the P-channel and N-channel MOSFETs of the respective CMOS inverters. In addition, since the above circuit has no delay circuit, even if the input pulse signal is of a narrow pulse width, the circuit can output an widened pulse signal without splitting the pulse signal.

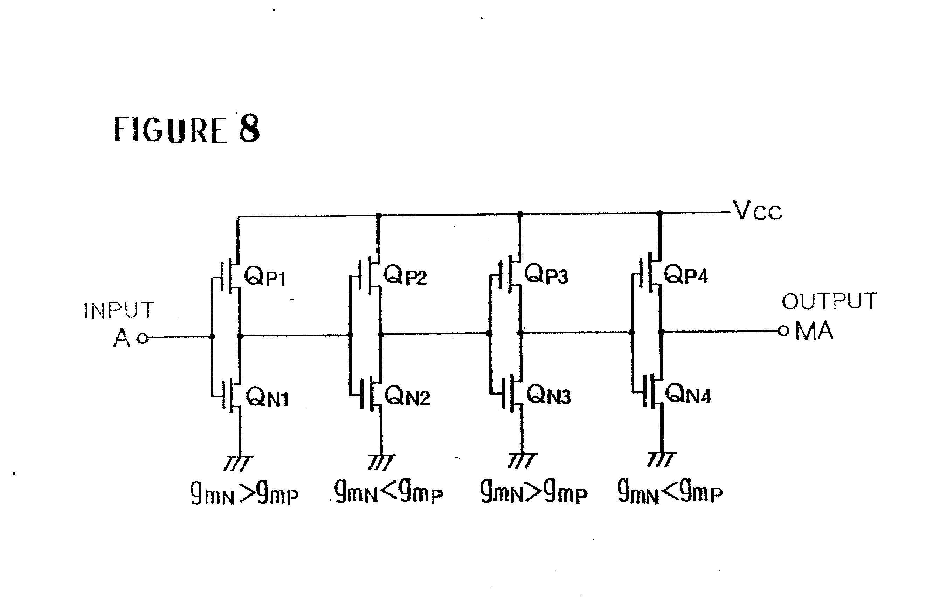

Referring to Figure 8, there is shown a transistor circuit diagram of the circuit shown in Figure 4 when it is constructed by silicon CMOS inverters. The transconductance $g_m$ of MOSFETs are expressed:

$$g_m = \mu \frac{\varepsilon_{ox} \cdot \varepsilon_o}{t_{ox}} \times \frac{W}{L} \qquad \ldots (3)$$

where $\mu$: mobility $= 450 \ cm^2/V \cdot S$ (N-channel)

$= 225 \ cm^2/V \cdot S$ (P-channel)

$\varepsilon_{ox}$: dielectric constant of the gate insulator

film $= 4.0 \ (SiO_2)$

$\varepsilon_o$: permittivity in vacuum $= 8.85 \times 10^{-14} \ F/cm$

$t_{ox}$: thickness of gate insulator $= 400$ angstroms

$W$: gate width

$L$: gate length $= 2$ micrometers

Under the above condition, the gate widths of the eight MOSFETs $Q_{p1}$ to $Q_{p4}$ and $Q_{N1}$ to $Q_{N4}$ in the circuit of Figure 8 were determined as shown in the following table:

<u>TABLE 1</u>

| | W ($\mu$m) | $g_{mp}$ ($\mu$S/V) | | W ($\mu$m) | $g_{mN}$ ($\mu$S/V) |
|---|---|---|---|---|---|
| $Q_{p1}$ | 10 | 100 | $Q_{N1}$ | 10 | 200 |
| $Q_{p2}$ | 20 | 200 | $Q_{N2}$ | 5 | 100 |
| $Q_{p3}$ | 10 | 100 | $Q_{N3}$ | 10 | 200 |
| $Q_{p4}$ | 20 | 200 | $Q_{N4}$ | 5 | 100 |

As a result, the respective MOSFETs had the transconductances as shown in the above table, and the pulse width modifying circuit has increased the pulse width by about 20 nanoseconds.

Turning to Figure 9, there is shown another embodiment of the pulse width modifying circuit in accordance with the present invention. In this embodiment, the odd-numbered CMOS inverters, i.e., the first and third CMOS inverters 4A and 4C are such that the P-channel MOSFET has a transconductance $g_{mp}$ larger than a transconductance $g_{mN}$ of an associated N-channel MOSFET. The even numbered CMOS inverters, i.e., the second and fourth CMOS inverters 4B and 4D are such that the transconductance $g_{mN}$ of the N-channel MOSFET is larger than the transconductance $g_{mp}$ of an associated P-channel MOSFET.

Accordingly, the delay time $\Delta t_L$ from the moment the input signal A changes from "1" to "8" to the moment the output signal MA changes from "1" to "0", is shorter than the delay time $\Delta t_H$ from the moment the input signal A changes from "0" to "1" to the moment the output signal MA changes from "0" to "1". Therefore, as seen from Figure 10, the duration of "0" in the input signal is enlarged.

The invention has thus been shown and described with reference to specific embodiments. However, it should be noted that the invention is in no way limited to the details of the illustrated structures but changes and modifications may be made within the scope of the appended claims. For example, the number of the cascade-connected inverters can be freely selected in accordance with the purpose of circuit design. If the number of the inverters is increased, the modifying amount of the pulse width is increased.

In addition, not only the increase of the pulse width in positive pulses but also the decrease of the pulse width in negative pulses can be performed by the pulse width modifying circuit of the same construction in accordance with the present invention.

**Claims**

1. A pulse width modifying circuit comprising at least one first type inverter and at least one second type inverter which are alternately connected in cascade to form an inverter train, the first type inverter being such that the delay of the rising edge of its output signal is larger than that of the falling edge of the output signal, and the second type inverter being such that the delay of the falling edge of its output signal is larger than that of the rising edge of the output signal.

2. A circuit as claimed in Claim 1 wherein the circuit comprises the same numbers of the first and second type inverters, and the first stage of the inverter train is the first type inverter.

3. A circuit as claimed in Claim 1 wherein circuit comprises the same numbers of the first and second type inverters, and the first stage of the inverter train is the second type inverter.

4. A circuit as claimed in Claim 1 wherein each first type inverter is a first type of complementary insulated gate field effect transistor (IGFET) inverter whose N-channel IGFET has a transconductance larger than that of an associated P-channel IGFET, and each second type inverter is a second type of complementary IGFET inverter whose P-channel IGFET has a transconductance larger than that of an associated N-channel IGFET.

5. A circuit as claimed in Claim 4 wherein the N-channel IGFET of the first type IGFET inverter has a transconductance as large as twice that of the associated P-channel IGFET, and the P-channel IGFET of the second type IGFET inverter has a transconductance as large as twice that of the associated N-channel IGFET.

6. A circuit as claimed in Claim 4 wherein the first and second types of complementary IGFET inverters include silicon metal-oxide-semiconductor - (MOS) FETs which have a gate insulator film whose dielectric constant is 4.0 and whose thickness is 400 angstroms, each of the MOSFETs having a gate length of 2 micrometers, the N-channel and P-channel MOSFETs of the first type inverters have the same gate width of 10 micrometers, and the N-channel and P-channel MOSFETs of the second type inverters have gate widths of 5 micrometers and 20 micrometers, respectively.

7. A pulse width modifying circuit comprising at least one first type of complementary metal-oxide-semiconductor (CMOS) inverter and at least one second type of CMOS inverter which are alternately connected in cascade to form an inverter train, the first type CMOS inverter including an N-channel MOS field effect transistor (FET) having a transconductance larger than that of an associated P-channel MOSFET, and the second type CMOS inverter including a P-channel MOSFET having a transconductance larger than that of an associated N-channel MOSFET.

8. A circuit as claimed in Claim 7 wherein the circuit comprises the same numbers of the first and second type CMOS inverters, and the first stage of the inverter train is the first type CMOS inverter.

9. A circuit as claimed in Claim 7 wherein the circuit comprises the same numbers of the first and second type CMOS inverters, and the first stage of the inverter train is the second type CMOS inverter.

10. A circuit as claimed in Claim 7 wherein the first and second types CMOS inverters include silicon metal-oxide-semiconductor (MOS) FETs which have a gate insulator film whose dielectric constant is 4.0 and whose thickness is 400 angstroms, each of the MOSFETs having a gate length of 2 micrometers, the N-channel and P-channel MOSFETs of the first type inverters have the same gate width of

10 micrometers, and the N-channel and P-channel MOSFETs of the second type inverters have gate widths of 5 micrometers and 20 micrometers, respectively.

# FIGURE 1    PRIOR ART

INPUT
A

DA

OUTPUT
MA

# FIGURE 2    PRIOR ART

INPUT
A

$t_P$

DELAYED
SIGNAL
DA

OUTPUT
MA

$\Delta t$    $\Delta t$

# FIGURE 3    PRIOR ART

INPUT
A

DELAYED
SIGNAL
DA

OUTPUT
MA

$\Delta t$

$\Delta t$

# FIGURE 4

A ○—▷○—• A1 —▷○—• A2 —▷○—• A3 —▷○—○ MA

4A     4B     4C     4D    3

$g_{mN} > g_{mP}$    $g_{mN} < g_{mP}$    $g_{mN} > g_{mP}$    $g_{mN} < g_{mP}$

# FIGURE 5

Vcc    4

P   $g_{mP}$

INPUT ○—————————○ OUTPUT

N   $g_{mN}$     C

# FIGURE 6

# FIGURE 7

# FIGURE 8

INPUT A○

OUTPUT ○ MA

$g_{mN} > g_{mP}$   $g_{mN} < g_{mP}$   $g_{mN} > g_{mP}$   $g_{mN} < g_{mP}$

0 198 254

# FIGURE 9

A o— $\triangleright$ 4A $\triangleright$ 4B $\triangleright$ 4C $\triangleright$ 4D —o MA

$g_{mN}<g_{mP}$ $g_{mN}>g_{mP}$ $g_{mN}<g_{mP}$ $g_{mN}>g_{mP}$

3

# FIGURE 10

INPUT
A

OUTPUT
MA

$\rightarrow \Delta t_L \leftarrow$     $\leftarrow \Delta t_H \rightarrow$

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-2 092 850 (RCA CORP.) <br> * figure 4A, elements I3, I4, figure 48; column 3, lines 38-52 * | 1,4,7 | H 03 K 5/04 |
| A | <br> * figure 2, elements 18, 20; column 2, lines 27-34 * <br><br> --- | 2,3,8, 9 | |
| A | PATENT ABSTRACTS OF JAPAN, vol. 3, no. 25 (E-94), 28th February 1979, page 22 E 94; & JP - A - 54 2046 (FUJITSU K.K.) 01-09-1979 <br><br> --- | | |
| P,A | IBM TECHNICAL DISCLOSURE BULLETIN, vol. 27, no. 12, May 1985, pages 7134, 7135; "CMOS delay circuit" <br><br> ----- | | **TECHNICAL FIELDS SEARCHED (Int. Cl.4)** <br><br> H 03 K 5/04 <br> H 03 K 5/13 <br> H 03 K 19/094 |

The present search report has been drawn up for all claims

| Place of search | Date of completion of the search | Examiner |
|---|---|---|
| BERLIN | 12-06-1986 | ARENDT M |